(19) Europäisches Patentamt / European Patent Office / Office européen des brevets

(11) **EP 2 337 222 B1**

(12) **FASCICULE DE BREVET EUROPEEN**

(45) Date de publication et mention
de la délivrance du brevet:
**27.04.2016 Bulletin 2016/17**

(51) Int Cl.:
***H03H 9/13*** *(2006.01)*      ***H03H 9/24*** *(2006.01)*

(21) Numéro de dépôt: **10354086.0**

(22) Date de dépôt: **03.12.2010**

(54) **Micro/Nano-résonateur compensé à détection capacitive améliorée et procédé d'élaboration**

Kompensierter Mikro-/Nanoresonator mit verbesserter kapazitiver Erkennung, und
Herstellungsverfahren

Compensated micro/nano-resonator with improved capacitive detection and method for producing same

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **10.12.2009 FR 0905974**

(43) Date de publication de la demande:
**22.06.2011 Bulletin 2011/25**

(73) Titulaire: **Commissariat à l'Énergie Atomique
et aux Énergies Alternatives
75015 Paris (FR)**

(72) Inventeurs:
• **Arcamone, Julien
38950 Saint-Martin-le-Vinoux (FR)**
• **Colinet, Eric
38240 Meylan (FR)**

(74) Mandataire: **Talbot, Alexandre et al
Cabinet Hecké
Europole
10, rue d'Arménie - BP 1537
38025 Grenoble Cedex 1 (FR)**

(56) Documents cités:
EP-A1- 1 538 747      WO-A1-2006/124303
WO-A2-02/17482      US-A1- 2004 065 940
US-A1- 2009 153 267      US-B1- 7 616 077

• YUAN XIE ET AL: "1.52-GHz Micromechanical
Extensional Wine-Glass Mode Ring Resonators",
1 avril 2008 (2008-04-01), IEEE TRANSACTIONS
ON ULTRASONICS, FERROELECTRICS AND
FREQUENCY CONTROL, IEEE, US, PAGE(S) 890
- 907, XP011208121, ISSN: 0885-3010 * page 903,
colonne 2, alinéa 3 - page 903, colonne 2, alinéa
3; figures 1b,20 c *
• PALANIAPAN M ET AL: "Micromechanical
resonator with ultra-high quality factor",
ELECTRONICS LETTERS, IEE STEVENAGE, GB,
vol. 43, no. 20, 27 September 2007 (2007-09-27),
pages 1090-1092, XP006029812, ISSN: 0013-5194,
DOI: 10.1049/EL:20072424

**Description**

**Domaine technique de l'invention**

L'invention est relative à un résonateur comportant un élément oscillant et des première et deuxième électrodes d'excitation de l'élément oscillant.

L'invention est également relative à un oscillateur et à un procédé de réalisation d'un tel résonateur excité au moyen de première et deuxième électrodes.

**État de la technique**

Afin de pouvoir continuer la course à la miniaturisation, les circuits microélectroniques doivent intégrer de nouvelles fonctions tout en minimisant la surface des circuits. Un des principaux domaines d'étude est l'intégration de dispositifs résonants à l'intérieur des puces. En effet, dans de nombreux domaines, tels que les bases de temps (les références temporelles), les capteurs chimiques en phase gazeuse, les capteurs de force moléculaire ou encore les spectromètres de masse, il est intéressant que le circuit intégré comporte au moins un oscillateur électromécanique. Les concepteurs travaillent à remplacer l'oscillateur qui est un composant discret supplémentaire par un oscillateur électromécanique (à base de microsystème résonant) intégré. En intégrant cet oscillateur, on peut alors espérer, en plus du gain en surface ou en volume du dispositif, un gain en énergie consommée et une amélioration des performances.

De manière conventionnelle, le résonateur comporte un élément oscillant qui se met en mouvement, à une fréquence donnée, autour d'une position fixe. Ce mouvement est maximal à la fréquence de résonance et quasi-nul en dehors. Le résonateur comporte également une électrode d'excitation qui applique la force nécessaire au mouvement de l'élément oscillant. Le résonateur comporte également une électrode de détection qui est influencée par la position de l'élément oscillant et qui produit un signal électrique représentatif de l'oscillation (signal maximal à la résonance et quasi-nul en dehors).

Le résonateur est caractérisé par un certain nombre de grandeurs représentatives du dispositif et de sa technologie de réalisation. Les résonateurs sont caractérisés par leur fréquence de résonance $f_0$ qui dépend des paramètres géométriques de l'élément oscillant et des matériaux qui le constituent. Le résonateur est également caractérisé par son facteur de qualité Q lié aux pertes énergétiques à l'intérieur du résonateur (plus les pertes sont faibles et plus le facteur de qualité est grand).

Dans le cas d'une détection capacitive du mouvement de l'élément oscillant, le comportement du résonateur (l'élément oscillant et les parties fixes) peut être modélisé au moyen d'un circuit de type RLC et d'une capacité parasite $C_{PA}$ connectée en parallèle. Lorsque l'élément oscillant se déplace à la fréquence de résonance, les valeurs de la capacité et de l'inductance s'annulent mutuellement et il ne reste dans le circuit RLC que la résistance dite motionnelle, notée $R_M$. Cette résistance motionnelle permet de caractériser la performance électromécanique du résonateur (plus la résistance motionnelle est petite et plus le résonateur est performant au sens où pour une tension d'excitation donnée, le résonateur va générer plus de courant).

Quelle que soit la structure mécanique utilisée, il existe toujours un couplage capacitif Cpa entre l'électrode d'excitation et l'électrode de détection. Ce couplage parasite induit un signal électrique, communément appelé « signal de fond », en l'occurrence un courant parasite de fond, noté $i_P$. Ce signal parasite est présent sur toute la plage de fréquence utilisée par le résonateur. Ce signal parasite se superpose au signal électrique de résonance qui provient du résonateur, en l'occurrence, le courant motionnel noté $i_M$.

Selon les cas de figure, le signal parasite peut partiellement ou totalement masquer le signal de résonance. De manière générale, l'influence néfaste d'une capacité parasite de couplage trop importante se traduit par quatre composantes :

(i) il existe un pic d'antirésonance qui est décalé par rapport au pic de résonance mécanique,
(ii) le gain relatif du signal du résonateur par rapport au signal de fond est diminué,
(iii) le changement de phase à la résonance est diminué car
(iv) le signal de fond est augmenté.

Il en résulte que l'obtention d'un oscillateur en boucle fermée à partir d'une détection capacitive des oscillations d'un tel résonateur est rendue difficile car le gain et le changement de phase sont diminués. Tout ceci provient du fait que la forme et l'information provenant du signal de détection capacitive sont modifiées voire gommées par la capacité parasite $C_{PA}$. Accessoirement, le fait d'avoir un signal de fond avec une amplitude importante (un signal de forte intensité) peut aboutir à la saturation du circuit électronique réalisant l'amplification du signal.

EP 1 538 747 A1 divulgue une structure de micro-résonateur capacitif excité au moyen de deux électrodes.

Différentes configurations de mesure ont été proposées afin de limiter l'influence du signal parasite lors de l'utilisation du résonateur à détection capacitive. Palaniapan et al. (« Micromechanical resonator with ultra-high quality factor », Electronics Letters, vol.43, n°20, September 2007) ont proposé une structure à détection différentielle qui atténue l'effet de la capacité parasite $C_{PA}$.

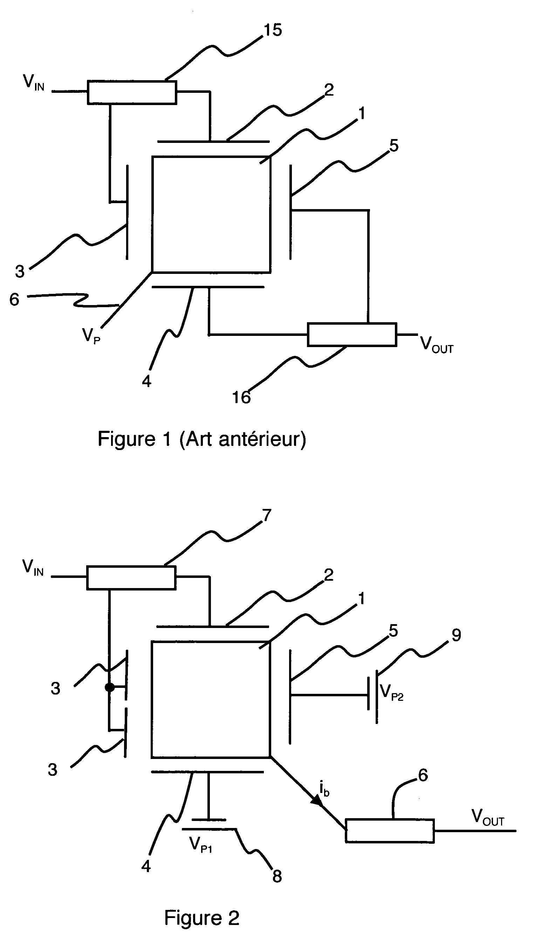

Comme illustré à la figure 1, le résonateur comporte un élément oscillant 1, des première 2 et deuxième 3 électrodes d'excitation, des troisième 4 et quatrième 5 électrodes de détection et une électrode additionnelle 6 qui est interconnectée à l'élément oscillant 1. Le résonateur comporte également un bloc de conversion 15 qui transforme un signal unique en deux signaux en opposition de phase, ce bloc 15 est connecté aux première 2 et deuxième 3 électrodes d'excitation. Ce bloc de conversion 15 applique sur les première 2 et deuxième 3 électrodes d'excitation des tensions de même amplitude mais en opposition de phase.

Un montage similaire est réalisé au niveau des électrodes de détection 4 et 5 afin d'obtenir le signal représentatif de l'oscillation de l'élément oscillant 1. Les troisième 4 et quatrième 5 électrodes sont connectées à un autre bloc de conversion 16 qui est différent et qui ressort un signal représentant la soustraction des signaux provenant des troisième 4 et quatrième 5 électrodes. Une tension de polarisation $V_P$ est appliquée à l'électrode additionnelle 6 qui est interconnectée électriquement avec l'élément oscillant 1.

Cette configuration de mesure apporte une réponse toute théorique à l'atténuation de l'effet de la capacité parasite $C_{PA}$ sur les caractéristiques du résonateur. En effet, pour réaliser l'élimination de la composante parasite, il est nécessaire que cette architecture comporte quatre électrodes exactement de même longueur, quatre entrefers électrode-résonateur exactement de même dimension. Il est également nécessaire que les pointes de test et/ou les lignes de connexions soient identiques en tous points. Dans la mesure où une telle architecture n'est pas réalisable d'un point de vue technologique, ni d'un point de vue de l'instrumentation, la problématique de l'effet de la capacité parasite sur les caractéristiques du signal de sortie reste posée.

Un problème identique de réalisation apparaît également de la publication de Xie et al (1,52-GHz Micromechanical Extensional Wine-Glass Mode Ring Resonators, IEEE transactions on ultrasonics, ferroelectrics, and frequency control, vol. 55, n°4, april 2008) qui utilise deux groupes d'électrodes reliées en elles selon un diamètre du résonateur à géométrie cylindrique. Différentes approches sont proposées pour éliminer ou réduire des modes de vibrations parasites mais il est toujours nécessaire d'avoir une structure parfaite d'un point de vue de la géométrie et des dimensions recherchées afin d'avoir une réduction de la composante parasite.

**Objet de l'invention**

L'invention a pour objet un résonateur qui permet la réduction voire l'élimination de l'effet des capacités parasites sur les caractéristiques de sortie du résonateur tout en ayant une mise en oeuvre facile.

Le résonateur selon l'invention est caractérisé par les revendications annexées et plus particulièrement par le fait qu'il comporte un résonateur tel que revendiqué dans la revendication indépendante 1.

L'invention a également pour objet un procédé qui soit facile à mettre en oeuvre et qui assure l'obtention d'un résonateur symétrique d'un point de vue du fonctionnement malgré la dissymétrie intrinsèque à la réalisation.

Le procédé selon l'invention est caractérisé tel que revendiqué dans la revendication indépendante 11.

**Description sommaire des dessins**

D'autres avantages et caractéristiques ressortiront plus clairement de la description qui va suivre de modes particuliers de réalisation de l'invention donnés à titre d'exemples non limitatifs et représentés aux dessins annexés, dans lesquels :

- la figure 1 représente, de manière schématique, un résonateur selon l'art antérieur,
- la figure 2 représente, de manière schématique, un résonateur selon l'invention,
- les figures 3 à 5, représentent, de manière schématique, différents modes de réalisation d'un résonateur, et différents modes de vibration de l'élément oscillant,
- la figure 6 représente, de manière schématique, un oscillateur obtenu au moyen d'un résonateur selon l'invention
- la figure 7 représente, de manière schématique, un mode de réalisation d'un oscillateur obtenu au moyen d'un résonateur selon l'invention,
- la figure 8 représente, de manière schématique, un autre mode de réalisation d'un oscillateur obtenu au moyen d'un résonateur.

**Description d'un mode de réalisation préférentiel de l'invention**

Comme illustré à la figure 2, le résonateur comporte un élément oscillant 1 et une pluralité d'électrodes disposées à distance de l'élément oscillant 1. L'élément oscillant est dans un matériau conducteur, ou semi-conducteur, par exemple un semi-conducteur dopé, qui peut être actionné par des forces électrostatiques. L'élément oscillant est solidaire du substrat par des points d'ancrage formés dans ou sur le substrat de support. Le résonateur est de taille micrométrique ou nanométrique et peut ainsi être réalisé au moyen des techniques conventionnelles de l'industrie de la microélectronique.

Un premier jeu d'électrodes d'excitation est formé au moins par une paire d'électrodes d'excitation, ici des première 2 et deuxième 3 électrodes d'excitation de l'élément oscillant 1. Selon les modes de réalisation, les première et seconde électrodes d'excitation peuvent être en regard ou non, mais les électrodes d'excitation sont toujours au moins partiellement en regard de l'élément oscillant 1. Dans une variante de réalisation, il est possible d'avoir une pluralité de premières électrodes d'excitation et/ou une pluralité de secondes électrodes d'excitation (électrodes 3 de la figure 2).

Le résonateur comporte au moins une troisième électrode 4 de polarisation. A titre d'exemple illustré à la figure 2, un deuxième jeu d'électrodes de polarisation est formé ici par des troisième 4 et quatrième 5 électrodes. Les troisième 4 et quatrième 5 électrodes de polarisation sont au moins partiellement en regard de l'élément oscillant et servent à créer dans l'élément oscillant un courant non nul pouvant être utilisé en sortie du résonateur. Chaque électrode sert également à déplacer l'élément oscillant, via la force électrostatique qu'elle impose, dans la direction perpendiculaire à son propre axe, et ceci afin de tendre à égaliser les forces électrostatiques des électrodes d'excitation par modification des entrefers (dues aux déplacements induits). Chaque électrode de polarisation est associée à une source de tension distincte.

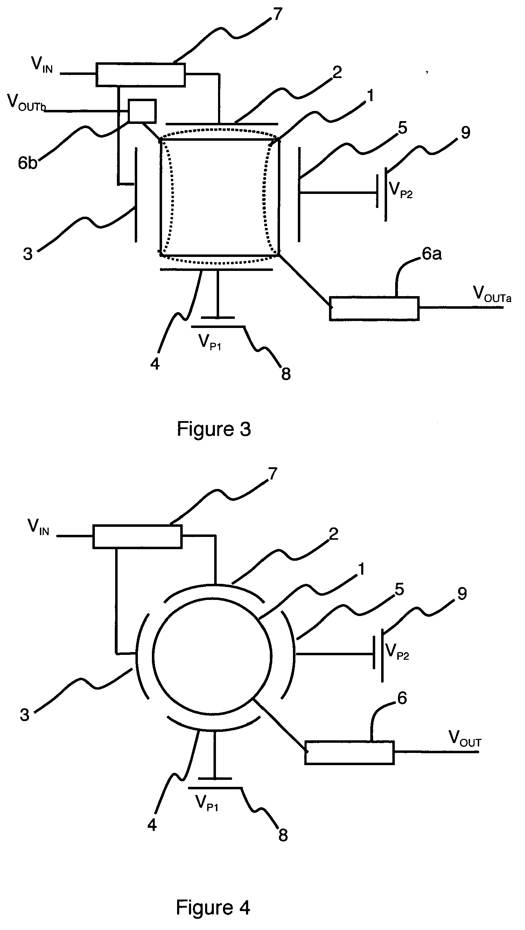

Le résonateur comporte également une électrode additionnelle 6 ou un jeu d'électrodes additionnelles 6a, 6b (figure 3) qui sont connectées électriquement à l'élément oscillant 1 et qui fournissent en sortie du résonateur un signal électrique représentatif de l'oscillation de l'élément oscillant 1 ($V_{OUTa}$ et $V_{OUTb}$). L'électrode additionnelle 6 est en un point tel que les influences capacitives des électrodes d'excitation s'égalisent et donc se neutralisent vue la nature différentielle de l'excitation. L'électrode additionnelle et sa connexion électrique, telle que sa piste métallique et/ou des fils de connexion, sont disposées de manière que les influences capacitives des électrodes d'excitation s'égalisent et se neutralisent. L'influence de la première électrode d'excitation est identique à l'influence de la seconde électrode d'excitation.

S'il existe un plan de symétrie entre les premières et seconde électrodes d'excitation, l'électrode additionnelle est localisée sur cet axe de symétrie et sa connexion électrique suit cet axe afin d'avoir des influences équivalentes ou égales de la part des premières et secondes électrodes d'excitation.

S'il n'existe pas de plan de symétrie, par exemple, car il n'y a pas le même nombre de premières et secondes électrodes d'excitation, ou la même disposition des électrode, ou la même surface en regard, la position de l'électrode additionnelle se décale par rapport au plan de symétrie défini précédemment afin de compenser les influences capacitives sur l'électrode additionnelle 6.

De manière générale, l'électrode additionnelle 6 est réalisée par tout moyen adapté, par un moyen de conduction placé sur l'élément oscillant et qui permet de faire sortir le signal de sortie.

Dans un mode de réalisation particulier, le signal de sortie $V_{OUT}$ du résonateur, c'est-à-dire le signal représentatif de l'oscillation de l'élément oscillant 1, est mesuré par l'intermédiaire d'un des points d'ancrage mécanique de l'élément oscillant 1. Ce point d'ancrage mécanique forme l'électrode additionnelle 6 et il doit être conducteur électriquement. L'électrode additionnelle est le point d'ancrage ou un des points d'ancrage situé dans le plan de symétrie ou à proximité du plan de symétrie s'il n'existe pas de point d'ancrage dans le plan de symétrie.

L'utilisation du point d'ancrage en tant qu'électrode additionnelle 6 permet de simplifier la structure et de faciliter la sortie du signal $V_{OUT}$. La connexion électrique à partir du point d'ancrage pour transmettre le signal de sortie est orientée de préférence selon l'axe de symétrie s'il existe sinon il est orienté de manière à compenser les influences capacitives des première et seconde électrodes d'excitation. De manière avantageuse, l'électrode additionnelle est formée par le point d'ancrage le plus éloigné des électrodes d'excitation afin d'avoir un signal de fond réduit.

L'élément oscillant 1 est, par exemple, de type plaque, de type disque ou de type poutre encastrée-encastrée ou encastrée-libre. Le mode de vibration du résonateur et son architecture, c'est-à-dire au moins de l'élément oscillant 1 et des électrodes d'excitation 2 et 3, sont tels que lorsque l'élément oscillant se rapproche de la première électrode d'excitation 2, il s'éloigne simultanément de la seconde électrode d'excitation. Avantageusement, lorsque l'élément oscillant 1 se rapproche d'une certaine distance d'une des électrodes d'excitation, il s'éloigne de la même distance de l'autre électrode d'excitation.

L'oscillation de l'élément oscillant est réalisée par tout moyen 7 pour faire osciller l'élément oscillant 1 par l'intermédiaire des électrodes d'excitation 2, 3 de manière à ce que l'élément oscillant 1 se rapprochant d'une des électrodes d'excitation, il s'éloigne de l'autre électrode d'excitation. Ce type d'oscillation peut être obtenu, par exemple, en appliquant des forces (ou des pressions selon la configuration) de même amplitude mais en opposition de phase en deux endroits distincts de l'élément oscillant 1. De manière classique, l'oscillation de l'élément oscillant est réalisée en disposant de manière judicieuse les électrodes d'excitation 2, 3 par rapport aux points d'ancrage.

A titre d'exemple illustré aux figures 2 à 7, l'oscillation peut être obtenue au moyen d'un dispositif de génération de deux signaux en opposition de phase 7, ici un coupleur directif (power splitter en anglais) est connecté aux première 2 et deuxième 3 électrodes d'excitation. Le dispositif de génération de signaux délivre sur les première 2 et deuxième 3 électrodes respectivement des premier et second signaux de même amplitude et en opposition de phase. De manière classique, le dispositif de génération des signaux en opposition de phase et de même amplitude n'est pas parfait et il peut exister des décalages que le résonateur (via son montage électrique) est en mesure de compenser. En d'autres termes, les signaux imposés sur les électrodes d'excitations comportent une composante alternative en opposition de phase comme cela est illustré aux figures 2 à 7, mais ils peuvent également comporter une composante continue (non illustrée).

Le dispositif de génération de deux signaux est par exemple un diviseur de puissance ou un coupleur directif 7 ayant une borne d'entrée et au moins des première 7a et seconde 7b bornes de sortie. Les première 7a et seconde 7b bornes de sortie sont respectivement connectées aux première 2 et deuxième 3 électrodes d'excitation. Un signal original d'excitation $V_{IN}$ est appliqué sur la borne d'entrée du diviseur de puissance 7 et est divisé en des tensions $V_{IN2}$ et $V_{IN3}$. Si le coupleur directif 7 est parfait, la tension $V_{IN2}$ sur la première borne de sortie 7a, donc sur la première électrode d'excitation 2 est opposée à la tension $V_{IN3}$ sur la seconde borne de sortie 7b, donc sur la deuxième électrode d'excitation 3 ($V_{IN2}=-V_{IN3}$). En sortie, le diviseur de puissance 7 délivre des premier et second signaux d'excitation respectivement sur les première 2 et deuxième 3 électrodes d'excitation. Les premier et second signaux d'excitation sont en opposition de phase, c'est-à-dire que leur différence de phase est égale à 180°. Les premier et second signaux présentent la même amplitude.

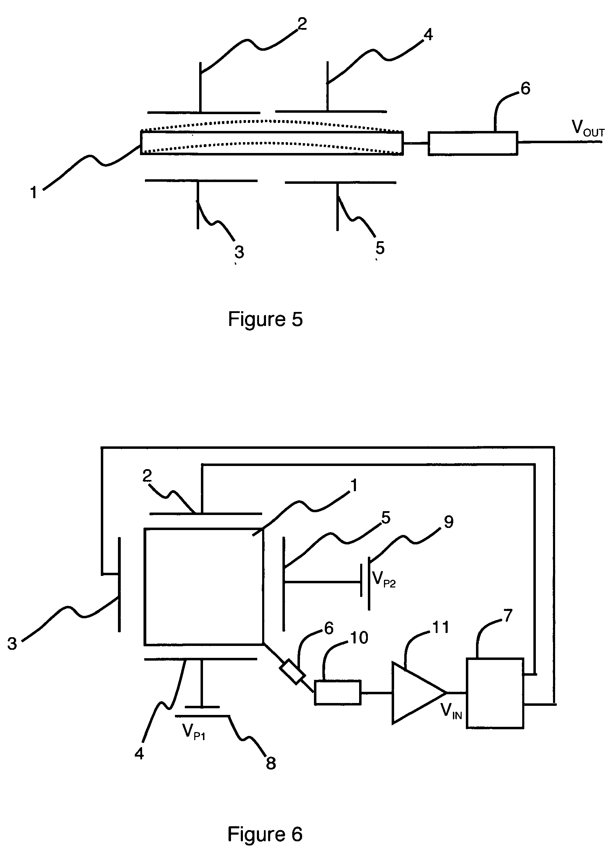

Les première 2 et deuxième 3 électrodes d'excitation ont pour but d'actionner de manière capacitive l'élément oscillant 1 qui vibre alors autour d'une position fixe. Avantageusement, l'élément oscillant vibre dans un mode de Lamé pour un élément oscillant de type plaque illustré à la figure 3, ou dans un mode de type elliptique (Wine-glass en anglais) pour un élément oscillant de type disque illustré à la figure 4 ou dans un mode en flexion pour une poutre encastrée-encastrée illustré à la figure 5. Pour un élément oscillant de type plaque ou disque qui vibre selon les modes ci-dessus, les première et seconde électrodes d'excitation ne sont en regard et elles sont avantageusement perpendiculaires entre elles. Pour un élément oscillant de type poutre encastrée-encastrée ou encastrée-libre, les première et deuxième électrodes d'excitation sont de part et d'autre de l'élément oscillant et de préférence en regard.

Chacune des électrodes de polarisation, ici les troisième 4 et quatrième 5 électrodes, comporte une borne d'application d'une tension de polarisation. Une première tension continue de polarisation $V_{P1}$ est appliquée sur la troisième électrode 4 et une seconde tension continue de polarisation $V_{P2}$ est appliquée sur la quatrième électrode 5. Ainsi, une première source de tension 8 continue est connectée à la troisième électrode 4 et une seconde source de tension 9 continue est connectée à la quatrième électrode 5. L'électrode de polarisation ou les électrodes de polarisation permettent de créer un courant dans l'élément oscillant et de déplacer la structure comme cela est expliqué précédemment. Ce courant induit dans l'élément oscillant est ensuite mesuré par l'électrode additionnelle 6 et sert à la détection du pic de résonance.

Afin de faciliter l'intégration du résonateur dans un circuit intégré, le signal de sortie peut être modifié par un circuit 10 de mise en forme qui isole tout ou partie du signal de sortie. Le circuit 10 de mise en forme est avantageusement formé dans le circuit intégré ou en même temps que le résonateur pour faciliter l'analyse du signal de sortie par le circuit 10 et conserver ainsi un résonateur compact. Avantageusement, le circuit de mise en forme 10 ne fournit que la composante alternative du signal $V_{OUT}$ délivré par l'élément oscillant 1 au moyen de l'électrode additionnelle 6.

Le circuit 10 de mise en forme peut être un T de polarisation (bias tee en anglais) ou un circuit actif connecté à l'électrode additionnelle 6. Le circuit 10 de mise en forme délivre alors le signal de sortie $V_{OUT}$ du résonateur. Le circuit actif est par exemple un amplificateur opérationnel qui comporte une résistance connectée en contre-réaction.

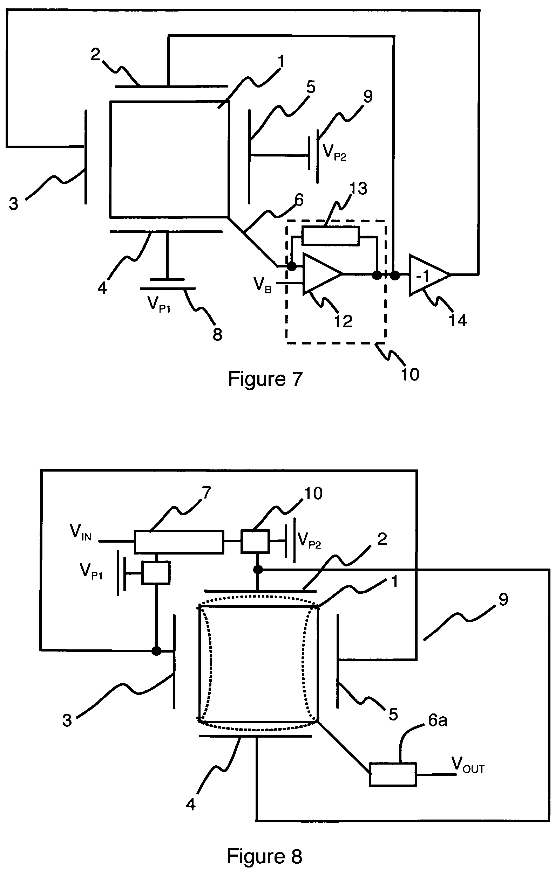

Dans un mode de réalisation avantageux illustré aux figures 6 et 7, permettant de former un oscillateur en boucle fermé, la transimpédance équivalente du circuit d'asservissement est égale ou sensiblement égale à celle de la résistance motionnelle du résonateur. Dans le mode particulier de réalisation de la figure 7 comportant un amplificateur opérationnel avec une résistance 13 montée en contre-réaction, la résistance 13 utilisée a une valeur égale ou sensiblement égale à celle de la résistance motionnelle du résonateur.

Le circuit 10 de mise en forme permet d'appliquer une tension continue $V_b$ au résonateur, sans que le signal de sortie $V_{OUT}$ ne présente cette composante continue et sans que le signal d'oscillation ne passe à travers le circuit 10 ce qui entraînerait un signal de sortie 10 nul.

Dans le cas idéal où l'architecture obtenue est symétrique, les capacités qui existent entre une face de l'élément oscillant 1 et chacune des électrodes de détection 2 et 3 et des deux autres électrodes 4 et 5 sont identiques en valeur. Elles sont toute égales à la capacité nominale dite « statique » qui existe quand l'élément oscillant 1 est au repos. Si la troisième tension continue $V_b$ est non nulle, les forces électrostatiques dynamiques d'excitation qui sont appliquées sur l'élément oscillant 1 sont de la forme générale :

$$F(t) \approx \frac{\varepsilon_0 S}{g^2} V_b V_{in}(t)$$

avec :

$V_b$ : la composante continue de la différence de potentiel qui existe entre les électrodes d'excitation et l'élément oscillant,

$V_{in}(t)$ : le signal alternatif d'excitation,

$S$ : la surface en regard entre une face de l'élément oscillant et une des électrodes d'excitation (en supposant que les surfaces sont identiques pour toutes les faces),

$g$ : l'entrefer entre une face de l'élément oscillant et une des électrodes d'excitation (en supposant que les entrefers sont identiques pour toutes les faces),

$\varepsilon_0$ : la constante diélectrique du milieu entre les électrodes et l'élément oscillant.

Les forces dynamiques provenant des première et deuxième électrodes d'excitation sont de signes opposées à cause de l'opposition de phase des signaux reçus par chacune des électrodes d'excitation.

On remarque qu'il est important d'avoir une composante continue $V_b$ non nulle de la différence de potentiel qui existe entre les électrodes d'excitation 2, 3 et l'élément oscillant 1 pour pouvoir appliquer une force électrostatique nécessaire à l'actionnement de l'élément oscillant et linéaire avec le signal d'excitation $V_{IN}$. Cette différence de potentiels $V_b$ qui représente la composante continue de la différence de potentiel doit exister entre les électrodes d'excitation et l'élément oscillant et doit être ajoutée à la composant alternative provenant du moyen 7 pour faire osciller l'élément oscillant 1.

L'électrode additionnelle 6 étant connectée électriquement à l'élément oscillant 1, il est possible dans un premier mode de réalisation particulier de polariser le résonateur par rapport aux électrodes d'excitation à une tension continue prédéfinie. L'électrode additionnelle continue de récupérer le signal électrique (c'est-à-dire un courant) produit par l'élément oscillant.

Dans un autre mode de réalisation particulier, une même tension continue additionnelle $V_b$, est appliquée sur les première 2 et deuxième 3 électrodes d'excitation, en plus des premier et second signaux d'excitation, tandis que l'élément oscillant est polarisé à un potentiel continu différent de Vb' par l'intermédiaire de l'élément 6. La tension appliquée aux électrodes d'excitation 2 et 3 comporte alors une composante continue et une composante alternative.

Ces deux modes de réalisation permettent d'appliquer la différence de potentiel recherchée entre les électrodes d'excitation et l'élément oscillant 1, mais il est également possible de les combiner afin que la différence de potentiel provienne partiellement de la tension appliquée sur les électrodes d'excitation 2, 3 et de la tension appliquée sur l'élément oscillant 1.

De manière générale, les courants induits dans le résonateur par les différentes électrodes se somment, ici les première 2, deuxième 3, troisième 4 et quatrième 5 électrodes. Les équation suivantes illustrent les structures particulières représentées avec deux électrodes d'excitation et deux électrodes de polarisation dans une architecture symétrique. Lorsque le résonateur se rapproche d'une électrode d'excitation, il s'éloigne d'une autre électrode d'excitation et il en va de même des électrodes de polarisation.

Le courant provenant des électrodes 4 et 5 est de la forme :

$$i_4 + i_5 \approx (V_{P1} - V_{P2})\frac{dc(t)}{dt} + 2C_0 \frac{dV_{OUT}}{dt},$$

avec

$i_4$ et $i_5$ étant respectivement les courants induits par les troisième 4 et quatrième 5 électrodes,

$V_{P1}$ et $V_{P2}$ étant respectivement les tensions de polarisation appliquées sur les troisième et quatrième électrodes,

$\dfrac{dc(t)}{dt}$ représentant la variation de la capacité électrique induite autour de la valeur au repos dans le temps,

$C_0$ la valeur de la capacité nominale au repos dans le temps (considérée comme identique pour les électrodes 4 et 5).

Ce courant présente deux composantes, une première composante dite « motionnelle » qui est fonction de la différence entre $V_{P1}$ et $V_{P2}$ et une seconde composante dite « de fond » qui dépend de la valeur de $C_O$.

Le courant provenant des électrodes 2 et 3 est de la forme :

$$i_2 + i_3 = (V_{IN2} + V_{IN3})\frac{dc(t)}{dt} + (C_{02} + C_{PA2})\frac{d(V_{IN2} - V_{OUT})}{dt} + (C_{03} + C_{PA3})\frac{d(V_{IN3} - V_{OUT})}{dt},$$

avec

$i_2$ et $i_3$ étant respectivement les courants induits par les première 2 et seconde 3 électrodes,
$V_{IN2}$ et $V_{IN3}$ étant respectivement les signaux appliquées sur les première 2 et seconde 3 électrodes,
$C_{O2}$ et $C_{O3}$ étant respectivement les valeurs des capacités nominales au repos dans le temps des première 2 et seconde 3 électrodes,
$C_{PA2}$ et $C_{PA3}$ étant respectivement les valeurs des couplages parasites liées aux première 2 et seconde 3 électrodes,
$V_{OUT}$ étant le signal de sortie.

Comme dans le cas précédent, le courant comporte une composante dite « motionnelle » qui dépend de la somme de $V_{IN2}$ et $V_{IN3}$ et une composante dite « de fond » qui dépend des valeurs des capacités nominales et parasites.

Si le diviseur de puissance 7 est parfait, les signaux $V_{IN2}$ et $V_{IN3}$ sont en opposition de phase, la somme devient nulle ou négligeable et il ne reste plus que la composante « de fond ».

Le courant de sortie total $i_b$ qui passe par l'électrode additionnelle 6 est la somme des courants induits par les électrodes d'excitation (ici les première 2 et deuxième 3 électrodes), par les électrodes de polarisation (ici les troisième 4 et quatrième 5 électrodes) et par les capacités parasites. Le courant de sortie total $i_b$ est en première approximation égal à la somme des trois courants précédents, c'est-à-dire :

$$i_b \approx (V_{P1} - V_{P2})\frac{dc(t)}{dt} + (C_{02} + C_{PA2})\frac{dV_{IN2}(t)}{dt} + (C_{03} + C_{PA3})\frac{dV_{IN3}(t)}{dt} + 2C_0\frac{dV_{OUT}(t)}{dt}$$

Ce courant comporte alors une composante liée à la résonance et qui provient des électrodes de détection et une composante liée aux capacités parasites.

Dans un cas particulier où le diviseur de puissance 7 est parfait c'est-à-dire qu'il délivre deux signaux parfaitement en opposition de phase, par exemple avec $V_{in}(t) = V_{IN2} = -V_{IN3}$ et avec une structure sensiblement symétrique, les capacités liées aux première et seconde électrodes sont égales ($C_{O2}=C_{O3}$) ainsi que les capacités parasites. La somme des courants i2 et i3 correspond à la somme des composantes parasites et est de la forme suivante :

$$i_2 + i_3 = i_{PA2} + i_{PA3} \approx C_{PA2}\frac{dV_{in}(t)}{dt} - C_{PA3}\frac{dV_{in}(t)}{dt}$$

avec,

$i_{PA2}$ et $i_{PA3}$ respectivement les courants induits par les première $C_{PA2}$ et seconde $C_{PA3}$ capacités parasites,
$C_{PA2}$ et $C_{PA3}$ respectivement les valeurs de capacité électrique des première et seconde capacités parasites,

$\dfrac{dV_{in}(t)}{dt}$ représentant la variation du signal d'excitation dans le temps.

De manière générale, la somme des courants induits par les première et seconde capacités parasites (composantes « de fond ») est non nulle, de valeur positive ou négative et très inférieure à la composante « motionnelle ». Si la somme $i_{PA2} + i_{PA3}$ est positive, la réponse fréquentielle présente un pic d'antirésonance placé après le pic de résonance dans le spectre fréquentiel, ce qui correspond théoriquement à la fonction de transfert d'un circuit RLC ayant une capacitance parasite $C_{PA}$ connectée en parallèle (comportement parasite de type capacitif). Si la somme est négative, la réponse fréquentielle présente un pic d'antirésonance placé avant le pic de résonance dans le spectre fréquentiel, ce qui correspond théoriquement à la fonction de transfert d'un circuit RLC ayant une capacitance parasite $C_{PA}$ virtuellement négative connectée en parallèle (comportement parasite de type inductif). De manière générale, il y a au moins autant de capacités parasites qu'il existe d'électrodes d'excitation.

Dans le cas idéal où l'architecture du résonateur est symétrique, le système est équilibré, les capacités formées par l'élément oscillant 1 et les première 2, deuxième 3, troisième 4 et quatrième 5 électrodes sont identiques. Le courant lié au fond disparaît et il ne reste plus que la courant de résonance.

Cependant, dans la pratique, l'architecture du résonateur est asymétrique car au moins une des capacités formées par les première, deuxième, troisième et quatrième électrodes et l'élément oscillant présente une valeur différente de celles des autres et/ou les tensions d'excitation sont en opposition de phase mais pas exactement de même amplitude.

L'architecture proposée, la configuration de mesure, est particulièrement avantageuse pour apporter une solution à l'utilisation d'un dispositif non symétrique. Grâce à cette architecture, il est possible de compenser les écarts à la symétrie provenant du procédé de fabrication et/ou de la non idéalité du moyen 7 au moyen des première $V_{P1}$ et seconde $V_{P2}$ tensions continues de polarisation et de la troisième tension continue $V_b$. En effet, suite aux variations inhérentes des procédés de fabrication utilisés, l'architecture du résonateur est souvent asymétrique, les capacités statiques des quatre électrodes ne sont pas identiques, ce qui peut provenir d'un décalage dans l'entrefer ou dans les surfaces en regard. Il est également envisageable que les deux capacités parasites identifiées ne soient pas parfaitement identiques et que la tension $V_{IN2}$ ne soit pas parfaitement égale à l'opposée de la tension $V_{IN3}$.

La modulation des valeurs des première $V_{P1}$ et seconde $V_{P2}$ tensions continues de polarisation et de la troisième tension continue $V_b$ permet de re-symétriser la structure. De cette manière, il est possible d'obtenir une architecture symétrique favorable à l'élimination de l'effet du signal de fond au moyen d'une compensation électrique des écarts dimensionnels existant et des écarts liés à l'instrumentation tels que par exemple des pointes de mesures, des fils de collages ou de liaison non orientés idéalement comme décrit précédemment et qui génèrent ainsi des capacités parasites ou des tensions d'excitation appliquées sur les électrodes 2 et 3 qui ne sont pas de même amplitude ou avec un déphasage égal exactement à 180°.

En pratique, un résonateur dit symétrique n'est obtenu qu'après une étape de réglage qui permet de compenser les différences d'entrefer, les différences de surface en regard et les différences de tension d'excitation Vin. L'étape de réglage est décrite plus loin. Lorsqu'une tension est appliquée sur une électrode de polarisation, il y a création d'une force qui va déplacer la position au repos de l'élément oscillant. De cette manière, les électrodes de polarisation, par exemple les troisième 4 et quatrième 5 électrodes de polarisation, permettent de moduler la distance qui sépare, au repos, l'élément oscillant 1 des première 2 et deuxième 3 électrodes d'excitation. L'électrode ou les électrodes de polarisation ont la double fonction d'assurer un courant induit non nul dans l'élément oscillant 1 et de moduler l'entrefer entre l'élément oscillant 1 et au moins une des électrodes d'excitation 2, 3.

Si le résonateur est symétrique ou sensiblement symétrique avant l'application d'une tension de polarisation sur une des électrodes de polarisation, il est avantageux de conserver cette symétrie en appliquant la même force continue suivant les deux directions d'oscillation définies par les électrodes d'excitation. Il peut également être envisagé d'utiliser une même électrode qui présente une ou des surfaces en regard de deux surfaces de l'élément oscillant.

Dans un mode de réalisation particulier, la troisième tension continue $V_b$ (appliquée par exemple au circuit de mise en forme) est fixée ainsi que la première $V_{P1}$ ou la seconde $V_{P2}$ tension de polarisation. La tension restante $V_{P2}$ ou $V_{P1}$ est ensuite ajustée par rapport à un critère prédéfini. Le critère prédéfini peut être, par exemple, l'élimination complète du pic d'antirésonance ou le fait d'atteindre une certaine valeur d'amplitude et de changement de phase à la résonance. A titre d'exemple, la troisième tension continue $V_b$ et la première tension de polarisation $V_{P1}$ sont fixées, la seconde tension de polarisation $V_{P2}$ est ensuite ajustée par rapport à un critère prédéfinie. La force électrostatique, à l'état statique, appliquée sur la troisième électrode 4 est proportionnelle au carré de la différence $(V_b-V_{P1})^2$ entre la troisième tension continue $V_b$ et la première tension de polarisation $V_{P1}$. Cette force électrostatique va déplacer la position d'équilibre statique de l'élément oscillant 1 dans la direction perpendiculaire à la surface de la troisième électrode 4 ce qui revient à modifier la distance effective qui sépare l'élément oscillant 1 de la première électrode 2 de détection et de la troisième électrode 4. De la même manière, la seconde tension de polarisation $V_{P2}$ modifie la position d'équilibre statique de l'élément oscillant 1 dans la direction perpendiculaire à la surface de la quatrième électrode 5.

Ainsi, au moyen de cette structure, il est possible de régler aisément la phase du résonateur. Comme montré précédemment, selon le signe de la somme $(i_{PA1}+i_{PA2})$, la réponse fréquentielle capacitive du résonateur comporte un signal de fond soit de nature capacitive (influence de la capacité parallèle parasite), soit de nature inductive (influence d'une pseudo-inductance, en d'autres termes une capacité virtuellement négative, parallèle parasite). Le fait que le résonateur puisse évoluer dans un régime capacitif ou inductif permet de régler le déphasage de l'entrée par rapport à la sortie du système. Ce réglage peut avoir lieu sur une large gamme en changeant le signe du produit $V_b(V_{P1} - V_{P2})$, par exemple en changeant le signe de la tension $V_b$ ou en réglant la différence $(V_b - V_{P1})$ avec une différence $(V_{P1} - V_{P2})$ constante.

L'application des tensions $V_{P1}$ et $V_{P2}$ permet de déplacer le résonateur, ce qui se traduit par une modification de sa raideur. Dans la mesure où la raideur intervient dans la formulation de la fréquence de résonance, la modulation des tensions $V_{P1}$ et $V_{P2}$ permet de moduler la fréquence de résonance du dispositif.

Dans un autre mode de réalisation, l'écart entre entrefers est corrigé selon deux directions orthogonales, c'est-à-dire selon la direction reliant la première électrode 2 de détection et la troisième électrode 4 et selon la direction reliant la seconde électrode 3 de détections et la quatrième électrode 5. La valeur de la troisième tension continue $V_b$ est fixée et on fait ensuite varier les valeurs des première $V_{P1}$ et seconde $V_{P2}$ tensions. Durant la variation de ces tensions, on peut choisir de maintenir une différence constante de potentiel entre les première $V_{P1}$ et seconde $V_{P2}$ tensions de polarisation. La valeur de la différence de potentiel est choisie de manière à obtenir une certaine valeur donnée de résistance motionnelle équivalente. En effet, si l'on veut construire un auto-oscillateur à partir de ce résonateur, la résistance motionnelle du résonateur doit être inférieure à une valeur maximale seuil de résistance motionnelle, un gain doit être supérieur à une valeur seuil et le changement de phase doit également être supérieur à une valeur seuil. En ajustant la troisième tension continue $V_b$ et la différence de potentiels entre les première $V_{P1}$ et seconde $V_{P2}$ tensions de polarisation, on joue alors sur des différences de potentiel entre la troisième tension continue $V_b$ et la première tension de polarisation $V_{P1}$ d'une part et entre la troisième tension continue $V_b$ et la seconde tension de polarisation $V_{P2}$ d'autre part. On obtient le gain et le changement de phase désirés pour remplir les conditions d'auto-oscillation.

Par ailleurs, il faut noter qu'au moyen de cette architecture, le calcul de la résistance motionnelle Rm est modifié. Dans ce cas de figure, la résistance motionnelle Rm est proportionnelle à l'inverse du produit de la différence de potentiels entre les première $V_{P1}$ et seconde $V_{P2}$ tensions de polarisation par la troisième tension continue $V_b$ appliquée sur le circuit 10 de mise en forme $R_M \propto \dfrac{1}{V_b(V_{P1} - V_{P2})}$, contrairement à l'art antérieur où il n'y a qu'une tension de polarisation $V_P$ et donc $R_M \propto \dfrac{1}{V_P^2}$. La résistance est donc fonction de trois tensions de polarisation $V_{P1}$ et $V_{P2}$, et $V_b$. Ceci représente un avantage très important dans la mesure où il n'y a aucune relation imposée entre la troisième tension continue $V_b$ et les deux tensions de polarisation $V_{P1}$ et $V_{P2}$. Il est donc possible d'obtenir une faible valeur de la résistance motionnelle Rm en modulant judicieusement la valeur des différentes tensions utilisées.

Si l'on souhaite travailler avec une résistance motionnelle prédéfinie, il est alors avantageux de diminuer la valeur de la troisième tension continue $V_b$ et de compenser cette baisse au moyen de la différence de potentiels entre les première $V_{P1}$ et seconde $V_{P2}$ tensions de polarisation. La diminution de la troisième tension continue $V_b$ permet de faire fonctionner le résonateur uniquement dans son régime mécanique linéaire ce qui est requis pour maintenir un bon bruit de phase et de ne pas conduire le résonateur au collage contre une des électrodes à cause d'une trop forte excitation.

Dans l'architecture présentée, le signe de la somme des courants parasites a une influence sur la réponse fréquentielle capacitive du résonateur. Selon le signe de cette somme des courants, la nature du signal de fond peut être soit capacitive (signe positif), soit inductive (signe négatif). Dans les deux cas, cela résulte de l'influence des capacités parallèles parasites mais tout dépend de leur valeur respective.

De manière générale, une architecture symétrique, c'est-à-dire une architecture qui permet d'éliminer l'influence des capacités parasites, est obtenue par l'application de première, seconde et troisième tensions continues qui ont pour effet de déplacer la position de l'élément oscillant 1 par rapport aux différentes électrodes présentes. Cette modification de la position de l'élément oscillant permet de modifier la valeur des condensateurs de manière à modifier les valeurs des capacités nominales des première et seconde électrode $C_{02}$ et $C_{03}$ et permettre à l'expression $[(C_{02} + C_{PA2}) \cdot \text{IN2} + (C_{03} + C_{PA3}) \cdot V_{IN3}]$ de tendre vers 0. Cette expression est représentative de la composante du courant de fond liée aux électrodes d'excitation. Il est également possible de réduire un défaut lié au diviseur de puissance 7 donc sur $V_{IN2}$ et $V_{IN3}$ en modulant les valeurs de $C_{02}$ et $C_{03}$ au moyen des tensions continues $V_{P1}$ et $V_{P2}$.

Dans un mode de réalisation particulier illustré à la figure 6, le résonateur est intégré pour former un oscillateur. Il est nécessaire d'ajouter des éléments supplémentaires afin que le circuit satisfasse aux conditions de Barkhausen en terme de gain et de phase. L'oscillateur comporte un circuit de réglage 11 du gain et du déphasage connecté aux moyens 7. Le réglage de phase qui est critique pour obtenir un oscillateur à partir d'un résonateur est facile à obtenir avec ce type de résonateur car, comme expliqué précédemment, il est possible d'obtenir aisément les conditions de phases nécessaires à l'obtention d'un oscillateur en ajustant le signe du produit $V_b(V_{P1} - V_{P2})$, puis en ajustant la valeur de la différence $(V_b - V_{P1})$ avec une différence $(V_{P1} - V_{P2})$ constante.

L'oscillateur comporte un circuit d'asservissement 10, 11 et 7 qui permet de fournir le gain et le déphasage nécessaires à la mise en auto-oscillation du résonateur. Le circuit d'asservissement permet de délivrer en sortie deux tensions de même amplitude et en opposition de phase. Le circuit d'asservissement peut être réalisé par exemple par un amplificateur associé à un diviseur ou séparateur de puissance (power splitter en anglais).

Ce mode de réalisation est particulièrement avantageux car cette architecture permet un meilleur équilibrage mécanique du résonateur notamment pour l'obtention d'entrefers identiques pour les électrodes d'excitation.

Dans un mode de réalisation particulier illustré à la figure 7, l'électrode additionnelle 6 est connectée à une première entrée d'un amplificateur 12 qui fait partie du circuit 10 de mise en forme. Une résistance 13 ayant une valeur au moins égale à celle de la résistance motionnelle Rm est connectée en contre réaction, c'est-à-dire entre la borne de sortie et la borne d'entrée connectée à l'électrode additionnelle 6. La troisième tension continue de polarisation Vb est appliquée sur la seconde entrée de l'amplificateur 12. La borne de sortie est connectée aux première et deuxième électrodes d'excitation de manière à fournir des signaux en opposition de phase et de même amplitude. Dans le mode de réalisation illustré, ceci est obtenu au moyen d'une connexion directe entre la borne de sortie et une des électrodes d'excitation alors que l'autre électrode d'excitation est connectée à la borne de sortie de l'amplificateur par l'intermédiaire d'un inverseur 14. Dans ce cas, l'association de l'inverseur 14 et de l'amplificateur 12 forme le moyen 7 et le circuit 10 de mise en forme.

Dans le mode de réalisation particulier illustré à la figure 8, les paires d'électrodes opposées sont soumises au même signal. Ainsi, l'électrode 3 et l'électrode 5 reçoivent le même signal. Il en va de même des électrodes 2 et 4. Le signal d'excitation $V_{INT}$ est appliqué à l'entrée des moyens 7 et chacune des sorties est polarisée. L'élément oscillant se rapproche du premier groupe d'électrodes tandis qu'il s'éloigne du second groupe d'électrodes. Dans ce mode de réalisation, il n'est pas possible de compenser un problème de symétrie car le même potentiel est appliqué sur deux électrodes opposées. En effet, dans les modes de réalisation précédent l'électrode de polarisation était distincte des électrodes d'excitation pour autoriser la modification du positionnement du résonateur en statique.

Il y a alors un groupe de premières électrodes d'excitation et un groupe de secondes électrodes d'excitation. Chaque groupe reçoit le même signal d'excitation. Les premier et second groupes d'excitation peuvent recevoir une composante alternative et une composante continue. Les composantes alternatives entre le premier et le second groupes d'électrodes sont en oppositions de phase ce qui permet de réduire le niveau du courant de fond en faisant tendre l'équation précédente vers 0. De cette manière, il est possible d'obtenir simplement une structure utilisant des groupes d'électrodes avec un signal de fond réduit.

A titre d'exemple, un premier jeu d'électrodes est polarisé au moyen de la tension $V_{P1}$ et le second jeu d'électrode est polarisé au moyen de la tension $V_{P2}$. De cette manière, les composantes alternatives en opposition de phase sont appliquées sur les deux jeux d'électrodes qui possèdent chacune une composante continue apportée par $V_{P1}$ ou $V_{P2}$.

## Revendications

1. Résonateur comportant :

   - un élément oscillant (1),
   - des première et deuxième électrodes (2, 3) d'excitation de l'élément oscillant (1) ayant chacune une face principale au moins partiellement en regard de l'élément oscillant (1),
   - des moyens d'application sur chaque électrode (2, 3) d'excitation d'un signal ayant une composante alternative pour faire osciller l'élément oscillant (1) par l'intermédiaire des électrodes (2, 3) d'excitation de manière que l'élément oscillant (1) se rapprochant d'une des électrodes d'excitation (2), il s'éloigne de l'autre électrode d'excitation (3),
   - une électrode additionnelle (6) connectée électriquement à l'élément oscillant (1),
   - des moyens d'application d'une différence de potentiel continue ($V_b$) entre l'élément oscillant (1) et les électrodes d'excitation (2, 3),
   - un signal ($V_{OUT}$) représentatif de l'oscillation de l'élément oscillant (1) fourni par l'intermédiaire de l'électrode additionnelle (6),

   résonateur **caractérisé en ce que** :

   - l'électrode additionnelle (6) est connectée électriquement à l'élément oscillant (1) en un point tel que les influences capacitives des électrodes d'excitation (2, 3) se neutralisent,
   - les composantes alternatives sont en opposition de phase entre les première et deuxième électrodes (2, 3) d'excitation et
   - une troisième électrode (4, 5) de polarisation distincte des première et deuxième électrodes d'excitation (2 ,3) présente une face principale au moins partiellement en regard de l'élément oscillant (1), la troisième électrode (4, 5) de polarisation étant connectée à une première source de tension continue et de manière à déplacer l'élément oscillant (1) par application d'une force électrostatique.

2. Résonateur selon la revendication 1 **caractérisé en ce que** le signal représentatif de l'oscillation de l'élément oscillant (1) est fourni par l'intermédiaire d'un circuit de mise en forme (10) connecté à l'électrode additionnelle (6).

3. Résonateur selon la revendication 2 **caractérisé en ce qu'**une troisième source de polarisation est connectée au circuit de mise en forme (10) pour appliquer une différence de potentiels ($V_b$) continue entre l'élément oscillant (1) et les électrodes d'excitation (2, 3).

**4.** Résonateur selon l'une des revendications 2 et 3, **caractérisé en ce que** le circuit de mise en forme (10) est un T de polarisation.

**5.** Résonateur selon l'une des revendications 2 et 3, **caractérisé en ce que** le circuit de mise en forme (10) est un amplificateur comportant une résistance montée en contre-réaction, la résistance ayant un valeur au moins égale à la résistance motionnelle de l'élément oscillant (1).

**6.** Résonateur selon l'une quelconque des revendications 1 à 5, **caractérisé en ce qu'**il comporte une pluralité de premières électrodes (2) d'excitation et/ou une pluralité de secondes électrodes (3) d'excitation, les premières électrodes (2) d'excitation et les secondes électrodes (3) d'excitation étant toutes respectivement dans des premier et second plans.

**7.** Résonateur selon l'une quelconque des revendications 1 à 6, **caractérisé en ce qu'**il comporte un plan de symétrie entre les premières (2) et secondes (3) électrodes d'excitation, l'électrode additionnelle (6) est le long du plan de symétrie.

**8.** Résonateur selon l'une quelconque des revendications 1 à 7, **caractérisé en ce que** l'électrode additionnelle est formée par un des points d'ancrage de l'élément oscillant (1).

**9.** Résonateur selon l'une quelconque des revendications 1 à 8, **caractérisé en ce qu'**il comporte une pluralité d'électrodes de polarisation (4, 5).

**10.** Oscillateur comportant un résonateur selon l'une quelconque des revendications 1 à 9, **caractérisé en ce qu'**il comporte un circuit d'asservissement (10, 11, 7) relié d'une part aux électrode d'excitation (2, 3) et d'autre part à l'électrode additionnelle (6).

**11.** Procédé de réalisation d'un résonateur comportant un élément oscillant (1) excité au moyen de première (2) et deuxième (3) électrodes, procédé **caractérisé en ce qu'**il comporte :

- l'application d'un signal d'excitation avec une composante alternative sur chacune des électrodes d'excitation (2, 3), les composantes alternatives étant en opposition de phase entre la première (2) et la seconde (3) électrode d'excitation,
- l'application d'une première tension ($V_{P1}$) continue de polarisation à une troisième électrode (4) pour déplacer l'élément oscillant (1) de manière à faire réduire la valeur de l'équation suivante :

$$\left[(C_{02} + C_{PA2}).V_{IN2} + (C_{03} + C_{PA3}).V_{IN3}\right] \text{ dans laquelle}$$

dans laquelle $C_{PA2}$ et $C_{PA3}$ sont respectivement les valeurs de capacité électrique des première et seconde capacités parasites liées aux électrodes d'excitation,
$V_{IN2}$ et $V_{IN3}$ sont les composantes alternatives appliquées respectivement à la première électrode d'excitation (2) et à la seconde électrode d'excitation (3),
$C_{02}$ et $C_{03}$ sont respectivement les valeurs des capacités nominales au repos dans le temps des première (2) et seconde (3) électrodes d'excitation,
- l'application d'une différence de potentiel continue ($V_b$) entre l'élément oscillant (1) et les électrodes d'excitation (2, 3),
- la mesure d'un signal de sortie ($V_{out}$) au niveau d'une électrode additionnelle (6) connectée électriquement à l'élément oscillant (1) en un point tel que les influences capacitives des électrodes d'excitation (2, 3) se neutralisent.

**Patentansprüche**

**1.** Resonator, umfassend:

- ein schwingendes Element (1),
- eine erste und eine zweite Elektrode (2, 3) zur Erregung des schwingenden Elements (1), die jeweils eine dem schwingenden Element (1) wenigstens teilweise gegenüberliegende Hauptseite aufweisen,

- Mittel zum Anlegen eines Signals mit einer Wechselkomponente an jede Erregerelektrode (2, 3), um das schwingende Element (1) mittels der Erregerelektroden (2, 3) schwingen zu lassen, so dass sich das schwingende Element (1), wenn es sich einer der Erregerelektroden (2) nähert, von der anderen Erregerelektrode (3) entfernt,

- eine zusätzliche Elektrode (6), die mit dem schwingenden Element (1) elektrisch verbunden ist,

- Mittel zum Anlegen einer kontinuierlichen Potentialdifferenz ($V_b$) zwischen dem schwingenden Element (1) und den Erregerelektroden (2, 3),

- ein für die Schwingung des schwingenden Elements (1) repräsentatives Signal ($V_{OUT}$), das mittels der zusätzlichen Elektrode (6) geliefert wird,

Resonator, **dadurch gekennzeichnet, dass**:

- die zusätzliche Elektrode (6) mit dem schwingenden Element (1) an einer Stelle elektrisch verbunden ist, die derart ist, die sich die kapazitiven Einflüsse der Erregerelektroden (2, 3) gegenseitig aufheben,

- die Wechselkomponenten zwischen der ersten und der zweiten Erregerelektrode (2, 3) gegenphasig sind und

- eine von der ersten und der zweiten Erregerelektrode (2, 3) getrennte dritte Polarisationselektrode (4, 5) eine dem schwingenden Element (1) wenigstens teilweise gegenüberliegende Hauptseite aufweist, wobei die dritte Polarisationselektrode (4, 5) mit einer ersten Gleichspannungsquelle und derart verbunden ist, dass das schwingende Element (1) durch Anlegen einer elektrostatischen Kraft bewegt wird.

2. Resonator nach Anspruch 1, **dadurch gekennzeichnet, dass** das für die Schwingung des schwingenden Elements (1) repräsentative Signal mittels einer mit der zusätzlichen Elektrode (6) verbundenen Formerschaltung (10) geliefert wird.

3. Resonator nach Anspruch 2, **dadurch gekennzeichnet, dass** eine dritte Polarisationsquelle mit der Formerschaltung (10) verbunden ist, um eine kontinuierliche Potentialdifferenz ($V_b$) zwischen dem schwingenden Element (1) und den Erregerelektroden (2, 3) anzulegen.

4. Resonator nach einem der Ansprüche 2 und 3, **dadurch gekennzeichnet, dass** die Formerschaltung (10) ein Bias-Tee ist.

5. Resonator nach einem der Ansprüche 2 und 3, **dadurch gekennzeichnet, dass** die Formerschaltung (10) ein Verstärker mit einem gegengekoppelten Widerstand ist, wobei der Widerstand einen Wert aufweist, der wenigstens gleich dem Bewegungswiderstand des schwingenden Elements (1) ist.

6. Resonator nach einem der Ansprüche 1 bis 5, **dadurch gekennzeichnet, dass** er eine Vielzahl von ersten Erregerelektroden (2) und/oder eine Vielzahl von zweiten Erregerelektroden (3) umfasst, wobei die ersten Erregerelektroden (2) und die zweiten Erregerelektroden (3) alle in einer ersten bzw. einer zweiten Ebene sind.

7. Resonator nach einem der Ansprüche 1 bis 6, **dadurch gekennzeichnet, dass** er eine Symmetrieebene zwischen den ersten (2) und zweiten (3) Erregerelektroden umfasst, wobei die zusätzliche Elektrode (6) sich entlang der Symmetrieebene befindet.

8. Resonator nach einem der Ansprüche 1 bis 7, **dadurch gekennzeichnet, dass** die zusätzliche Elektrode durch eine der Verankerungsstellen des schwingenden Elements (1) gebildet ist.

9. Resonator nach einem der Ansprüche 1 bis 8, **dadurch gekennzeichnet, dass** er eine Vielzahl von Polarisationselektroden (4, 5) umfasst.

10. Oszillator, umfassend einen Resonator nach einem der Ansprüche 1 bis 9, **dadurch gekennzeichnet, dass** er eine Regelungsschaltung (10, 11, 7) umfasst, die einerseits mit den Erregerelektroden (2, 3) und andererseits mit der zusätzlichen Elektrode (6) verbunden ist.

11. Verfahren zur Herstellung eines Resonators, der ein schwingendes Element (1) umfasst, welches mittels einer ersten (2) und einer zweiten (3) Elektrode erregt wird, Verfahren, **dadurch gekennzeichnet, dass** es umfasst:

- das Anlegen eines Erregersignals mit einer Wechselkomponente an jede der Erregerelektroden (2, 3), wobei die Wechselkomponenten zwischen der ersten (2) und der zweiten (3) Erregerelektrode gegenphasig sind,
- das Anlegen einer ersten Polarisationsgleichspannung ($V_{P1}$) an eine dritte Elektrode (4), um das schwingende Element (1) zu bewegen, um den Wert folgender Gleichung zu senken:

$$[(C_{02} + C_{PA2}).V_{IN2} + (C_{03} + C_{PA3}).V_{IN3}], \text{worin}$$

worin $C_{PA2}$ und $C_{PA3}$ jeweils die elektrischen Kapazitätswerte der mit den Erregerelektroden verbundenen ersten und zweiten parasitären Kapazitäten sind,

$V_{IN2}$ und $V_{IN3}$ die an die erste Erregerelektrode (2) bzw. an die zweite Erregerelektrode (3) angelegten Wechselkomponenten sind,

$C_{02}$ und $C_{03}$ jeweils die Werte der Nennkapazitäten zeitlich in Ruhe der ersten (2) und der zweiten (3) Erregerelektrode sind,

- das Anlegen einer kontinuierlichen Potentialdifferenz ($V_b$) zwischen dem schwingenden Element (1) und den Erregerelektroden (2, 3),
- das Messen eines Ausgangssignals ($V_{OUT}$) im Bereich einer zusätzlichen Elektrode (6), die mit dem schwingenden Element (1) an einer Stelle elektrisch verbunden ist, die derart ist, die sich die kapazitiven Einflüsse der Erregerelektroden (2, 3) gegenseitig aufheben.

**Claims**

1. A resonator comprising:

 - an oscillating element (1),
 - first and second excitation electrodes (2, 3) of the oscillating element (1) each having a main surface at least partially facing the oscillating element (1),
 - means for applying a signal having an AC component on each excitation electrode (2, 3) to make the oscillating element (1) oscillate by means of the excitation electrodes (2, 3) so that the oscillating element (1) moving towards one of the excitation electrodes (2), it moves away from the other excitation electrode (3),
 - an additional electrode (6) electrically connected to the oscillating element (1),
 - means for applying a DC voltage difference ($V_b$) between the oscillating element (1) and excitation electrodes (2, 3),
 - a signal ($V_{OUT}$) representative of oscillation of the oscillating element (1) provided via the additional electrode (6),

 a resonator **characterized in that**:

 - the additional electrode (6) is electrically connected to the oscillating element (1) at a point such that the capacitive influences of the excitation electrodes (2, 3) neutralize one another,
 - the AC components are in antiphase between the first and second excitation electrodes (2, 3) and
 - a third bias electrode (4, 5) different from first and second excitation electrodes (2, 3) has a main surface at least partially facing the oscillating element (1), the third bias electrode (4, 5) being connected to a first DC voltage source and serves the purpose of moving the oscillating element (1) via the electrostatic force.

2. The resonator according to claim 1 **characterized in that** the signal representative of oscillation of the oscillating element (1) is provided via a shaping circuit (10) connected to the additional electrode (6).

3. The resonator according to claim 2 **characterized in that** a third bias source is connected to the shaping circuit (10) to apply a DC voltage difference ($V_b$) between the oscillating element (1) and excitation electrodes (2, 3).

4. The resonator according to one of claims 2 and 3, **characterized in that** the shaping circuit (10) is a bias tee.

5. The resonator according to one of claims 2 and 3, **characterized in that** the shaping circuit (10) is an amplifier comprising a feedback-connected resistor, the resistor having a value at least equal to the motional resistance of the oscillating element (1).

6. The resonator according to any one of claims 1 to 5, **characterized in that** it comprises a plurality of first excitation electrodes (2) and/or a plurality of second excitation electrodes (3), the first excitation electrodes (2) and second excitation electrodes (3) all being respectively in first and second planes.

7. The resonator according to any one of claims 1 to 6, **characterized in that** it comprises a plane of symmetry between the first (2) and second (3) excitation electrodes, the additional electrode (6) being located along the plane of symmetry.

8. The resonator according to any one of claims 1 to 7, **characterized in that** the additional electrode is formed by one of the anchoring points of the oscillating element (1).

9. The resonator according to any one of claims 1 to 8, **characterized in that** it comprises a plurality of bias electrodes (4, 5).

10. An oscillator comprising a resonator according to any one of claims 1 to 9, **characterized in that** it comprises a closed-loop control circuit (10, 11, 7) connected on the one hand to the excitation electrodes (2, 3) and on the other hand to the additional electrode (6).

11. A method for producing a resonator comprising an oscillating element (1) excited by means of first (2) and second (3) electrodes, a method **characterized in that** it comprises:

- application of an excitation signal with an AC component on each of the excitation electrodes (2, 3), the AC components being in antiphase between the first (2) and second (3) excitation electrode,
- application of a first bias DC voltage ($V_{P1}$) to a third electrode (4) to move the oscillating element (1) so as to reduce the value of the following equation:

$$\left[(C_{02} + C_{PA2}).V_{IN2} + (C_{03} + C_{PA3}).V_{IN3}\right]$$

in which $C_{PA2}$ and $C_{PA3}$ are respectively the electric capacitance values of the first and second stray capacitances linked to the excitation electrodes,
$V_{IN2}$ and $V_{IN3}$ are the AC components respectively applied to the first excitation electrode (2) and to the second excitation electrodes (3),
$C_{02}$ and $C_{03}$ are respectively the values of the nominal rest capacitances as a function of time of the first (2) and second (3) excitation electrodes,
- application of a DC voltage difference ($V_b$) between the oscillating element (1) and excitation electrodes (2, 3),
- measurement of an output signal ($V_{OUT}$) on the additional electrode (6) electrically connected to the oscillating element (1) at a point such that the capacitive influences of the excitation electrodes (2, 3) neutralize one another.

$V_{IN}$

15

$V_{P}$

2

1

5

3

6

4

16

$V_{OUT}$

Figure 1 (Art antérieur)

$V_{IN}$

7

2

1

3

3

5

9

$V_{P2}$

4

$V_{P1}$

8

$i_{b}$

6

$V_{OUT}$

Figure 2

Figure 3

Figure 4

Figure 5

Figure 6

Figure 7

Figure 8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1538747 A1

**Littérature non-brevet citée dans la description**

- **PALANIAPAN et al.** Micromechanical resonator with ultra-high quality factor. *Electronics Letters,* Septembre 2007, vol. 43 (20

- **XIE et al.** 1,52-GHz Micromechanical Extensional Wine-Glass Mode Ring Resonators. *IEEE transactions on ultrasonics, ferroelectrics, and frequency control,* Avril 2008, vol. 55 (4